# FASCICULE DE BREVET EUROPEEN

(11) **EP 0 501 871 B1**
(45) Date de publication et mention de la délivrance du brevet: **06.09.1995**
(21) Numéro de dépôt: 92400481.5
(22) Date de dépôt: 25.02.1992
(51) Int. Cl.: H01S 3/106, H01S 3/19

(54) **Laser semi-conducteur à absorbeur saturable**
Halbleiterlaser mit sättigbarem Absorber
Semiconductor laser with saturable absorber

(30) Priorité: 27.02.1991 FR 9102352
(43) Date de publication de la demande: 02.09.1992
(73) Titulaire: ALCATEL N.V., NL-1077 XX Amsterdam (NL)
(72) Inventeur: Jacquet, Joel Alcatel Alsthom Recherche, F-91460 Marcoussis (FR); Leclerc, Denis, F-92340 Bourg la Reine (FR); Lievin, Jean-Louis, F-75012 Paris (FR); Sigogne, Didier, F-91140 Villebon Sur Yvette (FR)
(74) Mandataire: Bourely, Paul

(56) Documents cités:
- EP-A- 0 338 863
- PATENT ABSTRACTS OF JAPAN vol. 8, no. 49 (E-230)(1486) 6 Mars 1984;& JP-A-58202581

## Description

La présente invention a pour objet un laser constitué d'un matériau semiconducteur et comportant un absorbeur optique saturable. Un tel absorbeur présente une capacité d'absorption d'énergie lumineuse qui est limitée et appelée absorbance. Cette absorbance peut être commandée électriquement. Elle fait apparaître, sur le diagramme qui relie la puissance lumineuse émise par un tel laser à l'intensité d'un courant électrique alimentant ce laser, un cycle d'hystérésis dont la largeur est liée à cette absorbance et peut donc être, elle aussi, commandée électriquement. Un laser présentant un tel cycle est parfois dit bistable.

Les lasers semiconducteurs à absorbeurs saturables ont déjà fait l'objet de nombreuses publications et leurs utilisations potentielles pour le traitement de signaux optiques a suscité régulièrement de l'intérêt.

Un document d'origine japonaise (PATENT ABSTRACTS OF JAPAN, vol. 8, no. 49 (E-230) [1486], 6 mars 1984; 4 JP-A-58 202 581 (NIPPON DENSHIN DENWA KOSHA) 25-11-1983 décrit un laser connu de ce genre. Dans ce laser, deux électrodes supérieures se succédent au-dessus d'un guide de lumière. L'une injecte un courant d'alimentation à travers un amplificateur constitué par une section de ce guide. Ce courant traverse une jonction semiconductrice dans laquelle ce guide est inséré. Il injecte ainsi dans ce guide des porteurs de charges de types opposés, ce qui permet à cet amplificateur de réaliser l'amplification nécessaire à la croissance d'une oscillation lumineuse. L'autre électrode supérieure injecte un courant de commande d'absorbance dans un absorbeur saturable qui est constitué par une autre section de ce guide. Ce courant commande l'absorbance de cet absorbeur. Cet absorbeur est suivi d'un guide passif.

La présente invention vise à atteindre, notamment, certains au moins des buts suivants :
- Rapidité de la commande de l'absorbance de l'absorbeur d'un laser semiconducteur.
- Possibilité de commander cette absorbance à l'aide d'un faible courant.
- Facilité de réalisation d'un tel laser.

Et, dans ces buts, elle a pour objet un laser semiconducteur, comme revendiqué dans la revendication 1, dans lequel trois sections successives d'un guide de lumière constituent un amplificateur de lumière, un absorbeur saturable et une section passive, ce laser étant caractérisé par le fait qu'une électrode s'étend au moins partiellement sur cette section passive pour faire passer un courant de commande d'absorbance à travers cet absorbeur.

A l'aide des figures schématiques ci-jointes, on va décrire ci-après comment la présente invention peut être mise en oeuvre, étant entendu que les éléments et dispositions mentionnés et représentés ne le sont qu'à titre d'exemples non limitatifs.

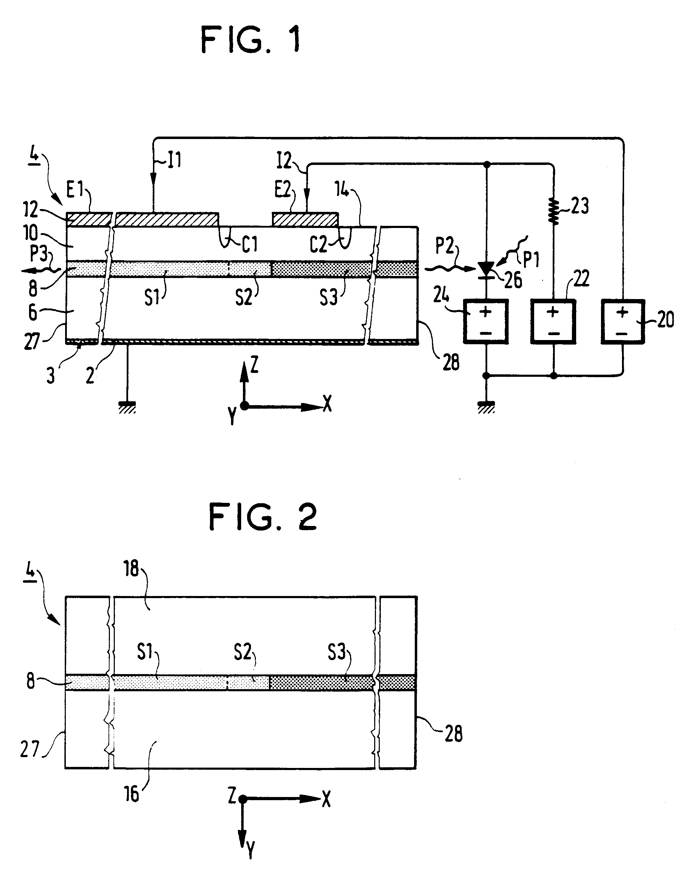

La figure 1 représente une vue en coupe longitudinale d'un dispositif incluant un laser et réalisant une mise en oeuvre de la présente invention.

La figure 2 représente une vue d'une plaquette semiconductrice de ce laser en coupe par un plan horizontal passant par une couche de guidage de lumière de ce laser.

Les figures 3 à 6 représentent des diagrammes de variation de la puissance optique émise par cette plaquette semiconductrice en fonction de l'intensité d'un courant d'alimentation injecté dans un amplificateur de cette plaquette, pour quatre valeurs de l'intensité d'un courant de commande d'absorption injecté dans un absorbeur de cette plaquette.

Le dispositif donné en exemple est un dispositif à rétroaction positive pour le traitement d'un signal optique. Il inclut un laser semiconducteur à absorbeur saturable. On va considérer d'abord ce laser et décrire de manière générale certaines dispositions adoptées pour sa réalisation. Ces dispositions sont analogues, quant à leurs fonctions indiquées, à des dispositions connues décrites dans un document Lasher (G.J. LASHER. "Analysis of a proposed bistable injection laser", Solid-state Electronics, Pergamon press 1964, vol 7, p707).

Selon ces dispositions un laser comporte un empilement des couches suivantes, ces couches se succédant selon une direction verticale Z définie par rapport à cet empilement :
- une couche d'électrode inférieure 2 sous une face inférieure 3 d'une plaquette semiconductrice 4,
- une couche de confinement inférieure 6 appartenant à cette plaquette semiconductrice et présentant un premier type de conductivité électrique et un indice de réfraction,
- une couche de guidage de lumière 8 comportant un guide de lumière S1, S2, S3 constitué au moins partiellement d'un matériau semiconducteur en continuité cristalline avec cette couche de confinement inférieure et présentant un indice de réfraction supérieur à celui de cette couche de confinement inférieure pour permettre de réaliser un confinement optique vertical dans cette couche de guidage,
- une couche de confinement supérieure 10 appartenant à ladite plaquette semiconductrice et présentant une continuité cristalline avec ce guide de lumière, un deuxième type de conductivité électrique opposé au premier, et un indice de réfraction inférieur à celui de ce guide de lumière pour réaliser ledit confinement optique vertical,
- et une couche d'électrodes supérieures 12 sur une face supérieure 14 de ladite plaquette semiconductrice.

Le guide de lumière S1, S2, S3 s'étend selon une direction longitudinale X dans la couche de guidage de lumière entre deux zones de confinement latérales 16, 18 dont les indices de réfraction sont choisis inférieurs à celui de ce guide pour réaliser un confinement optique transversal en confinant une lumière dans ce guide entre ces deux zones de confinement latérales. Il comporte une succession de sections selon la direction longitudinale d'arrière en avant : Une première section est un amplificateur de lumière S1. Une deuxième section est un absorbeur saturable S2 et constitue avec cet amplificateur un ensemble actif S1, S2. Cet ensemble actif est constitué d'un matériau actif semiconducteur choisi pour agir sur une lumière d'émission qui se propage avec une longueur d'onde d'émission selon cette direction longitudinale. Ce matériau est apte à être traversé par des courants électriques passant entre les deux couches de confinement inférieure et supérieure, l'intensité de tels courants étant comptée algébriquement dans un sens direct par rapport aux types de conductivité de ces deux couches. Ce matériau amplifie cette lumière dans cet amplificateur lorsqu'un tel courant électrique traversant cet amplificateur présente une densité de courant supérieure à un seuil d'amplification. Ce courant constitue alors un courant d'alimentation I1. Ce matériau absorbe cette lumière dans cet absorbeur lorsqu'un courant électrique traversant cet absorbeur présente une densité de courant inférieure à ce seuil d'amplification. Ce courant constitue alors un courant de commande d'absorbance I2. Cet absorbeur absorbe une énergie nouvelle de cette lumière seulement dans la mesure où l'énergie de cette lumière qu'il a déjà absorbée et accumulée pendant une période de conservation d'énergie est inférieure à son absorbance, cette période de conservation d'énergie ayant une durée limitée et précédant et incluant l'instant où cet absorbeur reçoit cette énergie nouvelle. Cette absorbance est commandée par ce courant de commande.
- La couche d'électrodes supérieures comporte :
- une électrode d'alimentation E1 localisée pour transmettre un dit courant d'alimentation I1 vers la couche d'électrode inférieure 2 à travers l'amplificateur S1,
- et une électrode de commande d'absorbance E2 localisée pour transmettre un dit courant de commande d'absorbance I2 vers la couche d'électrode inférieuie à travers l'absorbeur S2.

Ce laser comporte encore :
- une source d'alimentation 20 pour fournir ce courant d'alimentation à cette électrode d'alimentation,
- et une source de commande d'absorbance 22, 23, 24, 26 pour fournir ce courant de commande d'absorption à l'électrode de commande E2.

Des moyens de réflexion de lumière 27, 28 sont disposés de part et d'autre longitudinalement de l'ensemble actif S1, S2 pour que la plaquette semiconductrice 4 constitue un émetteur de lumière émettant ladite lumière d'émission. Ils sont constitués, dans le dispositif donné en exemple, par les faces arrière 27 et avant 28 de la plaquette 4, ces faces étant partiellement réflèchissantes pour constituer un résonateur Fabry-Perot. Ils pourraient aussi être constitués par des miroirs externes ou par un réflecteur de Bragg distribué interne à cette plaquette.

De manière habituelle les électrodes d'alimentation E1 et de commande d'absorbance E2 présentent la forme de rubans ayant, selon une direction transversale Y, des longueurs supérieures à la largeur du guide de lumière S1, S2, S3, des moyens de confinement électrique latéral étant prévus pour empêcher, au moins partiellement lesdits courants d'alimentation I1 et de commande d'absorption I2 de passer à travers lesdites zones de confinement latérales 16, 18. Ces moyens de confinement électrique peuvent être notamment constitués par une composition ou structure interne convenable de ces zones de confinement.

Le guide de lumière S1, S2, S3 comporte en outre, au sein de la plaquette semiconductrice 4 et à l'avant de l'absorbeur S2, une troisième section constituée d'un matériau passif choisi pour transmettre ladite lumière d'émission sans agir sensiblement ni sur son intensité ni sur sa vitesse de propagation, cette section constituant une section passive S3.

Ce guide peut être simple, chacune de ses sections étant en continuité géométrique avec les précédentes. Les couplages entre sections sont alors longitudinaux. Ce guide peut aussi être composite, par exemple constitué de deux sous couches superposées. Le couplage entre l'absorbeur et la section passive peut alors être un couplage vertical couplant mutuellement ces deux couches.

De plus ce guide peut comporter d'autres sections qui peuvent être, par exemple, une section de décalage de phase et une section d'accord de fréquence telles que décrites dans un document KONDO pour réaliser un laser à fréquence commandée (K. KONDO; H.NOBUHARA; S.YAMAKOSHI. "Giga-bit operation of wavelength conversion laser". Paper 13D-9, Conférence "Photonic Switching 90", 12-14 Avril 1990, KOBE, Japon)

Par ailleurs certains composants non représentés pourraient être intégrés à la plaquette semiconductrice. Tel pourrait être, notamment le cas d'une photodiode appartenant à la source de commande d'absorbance ou d'un amplificateur de lumière supplémentaire externe à la cavité résonante du laser.

Conformément à la présente invention, l'électrode de commande d'absorbance E2 s'étend au moins partiellement au-dessus de la section passive S3. Cette disposition permet à cette électrode de présenter, selon la direction longitudinale, une dimension supérieure à la longueur de l'absorbeur. Lorsque, ce qui est souvent le cas, cette longueur est plus petite que la largeur d'un ruban métallique que l'on sait former facilement pour réaliser cette électrode, cette diposition permet de réaliser facilement cette électrode. Elle permet en même temps de réaliser un absorbeur plus court que la largeur de cette électrode, ceci permettant au laser de répondre rapidement aux variations du courant de commande d'absorbance.

On peut adopter en outre certaines au moins des dispositions avantageuses qui vont être maintenant décrites de manière générale et qui, sauf indication contraire, sont adoptées dans le mode de mise en oeuvre donné en exemple.

Une telle disposition peut être adoptée grâce à la présence de la section passive S3. Elle l'est avec avantage lorsque l'on souhaite que la plaquette 4 présente une face avant clivée 28. Selon cette disposition cette face avant est formée à une extrémité avant de la section passive S3. Cette disposition permet de réaliser la face avant de la plaquette par une opération de clivage habituelle dont on sait qu'elle entraîne une imprécision sur la position de la face ainsi réalisée. Cette imprécision est acceptable parce qu'elle affecte seulement la longueur de la section passive, alors qu'en l'absence de cette section, cette imprécision affecterait la longueur de l'absorbeur et empêcherait donc d'obtenir de manière reproductible une grande vitesse de réponse du laser au courant de commande d'absorbance.

Selon une autre disposition avantageuse l'amplificateur S1 et l'absorbeur S2 sont connectés optiquement à un composant optique 26 par l'intermédiaire de la section passive S3. Cette disposition facilite la réalisation d'un circuit optique incluant la plaquette 4. Ce composant est par exemple une photodiode 26 qui constitue un récepteur de lumière et fait partie de la source de commande d'absorbance 22, 23, 24, 26.

La présence de la section passive S3 pourrait présenter l'inconvénient de dévier une partie du courant de commande d'absorbance. C'est pourquoi selon une autre disposition avantageuse le laser comporte un obstacle au courant électrique sur au moins certains des trajets qui vont de l'électrode de commande d'aborbance E2 à la couche d'électrode inférieure 2 en passant à travers la section passive S3. Cette disposition permet de réaliser une commande efficace en utilisant une source de commande d'absorbance fournissant un courant de relativement faible intensité, ceci parce qu'une fraction efficace relativement importante de ce courant passe à travers l'absorbeur alors que la condition à remplir relativement à ce courant pour réaliser une commande efficace est que cette fraction efficace ait une intensité suffisante.

Une disposition particulière de réalisation dudit obstacle au courant électrique résulte du fait que la résistivité électrique du matériau passif de la section S3 est sensiblement supérieure à celle du matériau actif des sections S1 et S2. Cette dernière disposition constitue un mode de réalisation de la disposition précédente. Elle peut être particulièrement efficace. Elle n'est pas appliquée dans le dispositif donné en exemple alors que la disposition qui va être maintenant indiquée et qui est particulièrement facile à réaliser y est appliquée.

Selon cette autre disposition avantageuse des canaux d'isolation électrique sont formés dans la plaquette semiconductrice 4 à partir de sa dite face supérieure 14. Un canal d'isolation arrière C1 est localisé longitudinalement entre l'électrode d'alimentation E1 et l'absorbeur S2. Un canal d'isolation avant C2 est localisé longitudinalement au voisinage du bord avant de l'électrode de commande E2 et il constitue ledit obstacle au courant électrique.

Le laser dont diverses dispositions viennent d'être décrites émet ladite lumière d'émission, sous la forme d'un faisceau P3, en réponse à un signal d'entrée de nature électrique tel que le courant de commande d'absorbance I2. Par contre le dispositif de traitement de signal optique qui inclut ce laser émet cette lumière en réponse à un signal d'entrée de nature optique. Ce signal d'entrée est constitué par un faisceau lumineux P1 reçu par la photodiode 26 qui constitue un récepteur de lumière inclus dans la source de commande d'absorbance. Ce faisceau commande un courant qui traverse cette photodiode et qui constitue, pour partie, le courant de commande d'absorbance I2. Il commande ainsi un signal de sortie de nature optique constitué par le faisceau P3.

L'intensité du courant fourni par ce récepteur de lumière peut être très petite. Cette petitesse facilite la réalisation du dispositif. D'autre part elle permet d'utiliser un récepteur 26 à réponse rapide tel qu'une photodiode rapide du type PIN polarisée en inverse. L'emploi d'une telle polarisation de cette photodiode est rendu possible, sans créer un risque de détérioration de la plaquette 4, par le fait que le courant I2 est de sens direct. Cette polarisation est par exemple réalisée par une source de potentiel 24. Le courant I2 est constitué par la somme du courant traversant cette photodiode et d'un courant de prépolarisation fourni par une autre source de potentiel 22 à travers une résistance 23. Ces deux sources de potentiels et cette photodiode constituent ensemble la source de commande d'absorbance.

On va maintenant donner de manière plus particulière diverses indications sur les éléments précédemment mentionnés.

La plaquette 4 a été réalisée à partir d'un substrat de phosphure d'indium InP dopé n par épitaxie en phase liquide. Les matériaux actif (sections S1 et S2) et passif (section S3) utilisés seront dits ci-après de type 1 et 2. Ce sont des alliages quaternaires non intentionnellement dopés. Ils sont constitués d'indium, de gallium, d'arsenic et de phosphore du type In₁₋ₓGaₓAs_{y}P_{1-y} et accordés en maille avec le substrat. Ces matériaux présentent, respectivement des bandes interdites correspondant à des longueurs d'onde de 1 530 nm et 1 300 nm. La première de ces deux longueurs constitue ladite longueur d'onde d'émission. Les matériaux de confinement, c'est-à-dire ceux des couches de confinement, sont le substrat d'InP dopé n pour la couche de confinement inférieure 6 et une couche épitaxiée d'InP dopé p pour la couche de confinement supérieure 10. Une couche de contact épitaxiée n'est pas représentée. Son épaisseur est 200 nm. Elle est constituée d'un matériau de contact quaternaire de type 2 et fortement dopée p. Elle est présente sous les électrodes E1 et E2.

La plaquette 4 a été réalisée selon la filière technologique dite du phosphure d'indium, mais son principe de réalisation peut être transféré à tout système de matériaux semiconducteurs tel que celui de la filière arséniure de gallium, GaAs. Les matériaux de type 1 et 2 peuvent également être remplacés par des structures plus complexes telles que des structures à multi-puits quantiques, à super réseaux, ou à empilement de couches de matériaux différents, dopés ou non. Il suffit que la structure mise en place du matériau 1 présente un gain optique à la longueur d'onde d'émission désirée et que la structure mise en place du matériau de type 2 soit transparente pour cette même longueur d'onde.

Les matériaux actif et'passif doivent être entourés de part et d'autre par des matériaux de confinement également transparents à la longueur d'onde d'émission, afin de constituer un guide d'onde monomode. Un matériau sera dit transparent si son absorption linéique est typiquement inférieure à 50 cm⁻¹. Les différents éléments de la plaquette 4 réalisée peuvent être précisés comme suit :
- Amplificateur S1 et absorbeur S2 constitués de matériau de type 1, dit actif présentant un gain optique maximal à la longueur d'onde d'émission et non-intentionnellement dopé n à 10¹⁷ cm⁻³.
- Section passive S3 constituée de matériau de type 2, dit passif, transparent pour la longueur d'onde d'émission, présentant un gain optique maximal à la longueur d'onde de 1 300 nm, dopé n à 5.10¹⁷ cm⁻³.
- Couche de confinement supérieure 10 de type InP dopée p avec une concentration comprise entre 10¹⁷ et 2.10¹⁸cm⁻³, d'épaisseur typiquement supérieure à 1000 nm.
- Couche de confinement inférieure 6 de type InP, dopée n avec une concentration comprise entre 10¹⁷ et 5.10¹⁸ cm⁻³, d'épaisseur supérieure à 1000 nm.
- Absorbeur S2 non directement alimenté par l'électrode E1. Il présente une absorbance saturable à la longueur d'onde d'émission. Sa longueur typique peut varier entre 0,005 et 0,025 mm. Sa longueur réalisée est, par exemple, de 0,01 mm.
- La dimension de l'électrode E1 selon ladite direction longitudinale peut typiquement varier entre 0,1 et 0,6 mm, par exemple 0,4 mm.
- L'électrode de commande d'absorbance E2 est typiquement située au voisinage de la transition (à une distance inférieure à 0,01 mm) entre les matériaux actif et passif et donc de l'absorbeur saturable. Sa dimension, selon la direction X peut varier entre 0,001 et 0,1 mm. Elle détermine directement la valeur du courant de commande I2. Il y a intérêt à rendre cette électrode la plus étroite possible, une valeur réalisée étant de 0,085 mm.
- Les canaux d'isolement C1 et C2 sont creusés dans le matériau de contact (non-représenté) et la couche de confinement supérieure 10 afin de déterminer les valeurs des résistances entre sections ou entre électrodes. Ces canaux peuvent typiquement avoir une largeur de 0,005 mm et une profondeur égale au 3/4 de l'épaisseur totale du matériau de contact et du matériau de confinement supérieur.
- La résistance électrique entre l'électrode d'alimentation E1 et l'absorbeur saturable S2 peut varier entre 100 ohms et 10 000 ohms. On a testé les valeurs 200 ohms et 1 400 ohms.
- La résistance électrique entre l'électrode de commande d'absorbance E2 et l'absorbeur saturable S2 a été testée avec une valeur de 20 ohms.

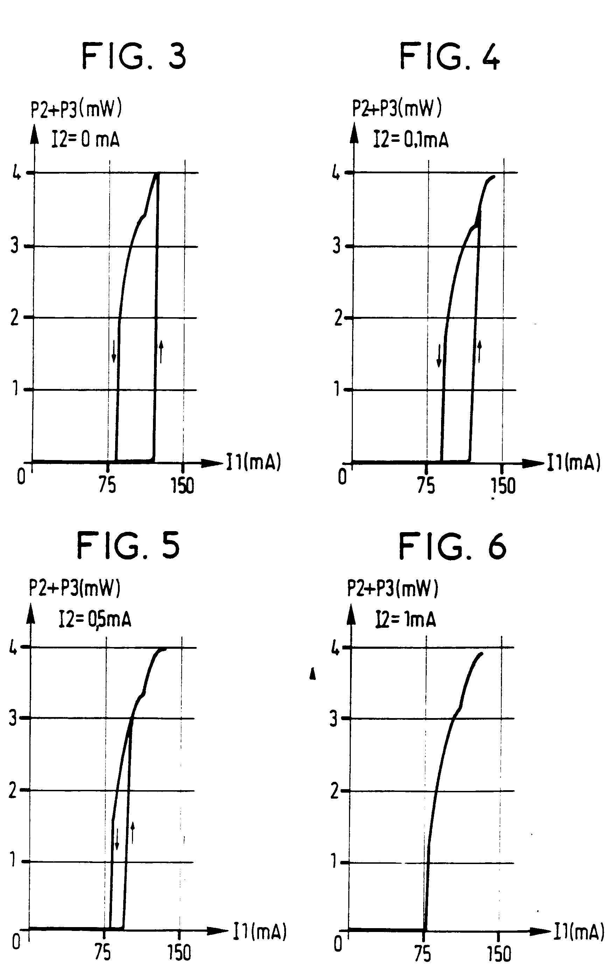

Les figures 3, 4, 5 et 6 représentent le comportement du laser réalisé décrit ci-dessus par quatre valeurs du courant de commande I2 respectivement 0-0,1-0,5 et 1 mA. Elles montrent le cycle d'hystérésis de la puissance optique émise (en ordonnée) en fonction de l'intensité du courant (en abscisse) injecté dans le laser à travers l'électrode d'alimentation E1.

Il est remarquable qu'une intensité du courant I2 aussi faible que 0,1 mA permette de commander l'absorbance de l'absorbeur saturable. Une fermeture complète du cycle d'hystérésis est obtenue pour une variation de I2 inférieure à 1 mA. Une augmentation de I2 réduit principalement la valeur du courant I1 provoquant l'émission lumineuse, mais il est important de constater que la valeur du courant I1 provoquant l'extinction est également réduite.

Un intérêt important de la présente invention réside donc dans le fait que l'on peut commander la largeur du cycle d'hystérésis d'un laser à semiconducteur bistable par des courants de commande très faibles typiquement inférieurs au mA et qu'en plus cette commande se fait avec une polarisation directe de la jonction semiconductrice qui reçoit ce courant au sein de ce laser. Ceci permet de réaliser plus facilement un dispositif de traitement à rétroaction dans lequel le signal électrique interne I2 est fourni par une photodiode polarisée en inverse telle que 26.

## Revendications

1. Laser semiconducteur à absorbeur saturable dans lequel trois sections successives d'un guide de lumière semiconducteur longitudinal constituent un amplificateur de lumière (S1), un absorbeur saturable (S2) et une section passive (S3), une électrode d'alimentation (E1) étant disposée sur ce laser pour faire passer un courant d'alimentation (I1) à travers cet amplificateur, une électrode de commande d'absorbance (E2) étant disposée sur ce laser pour faire passer un courant de commande d'absorbance (I2) à travers cet absorbeur, ce laser étant caractérisé par le fait que l'électrode de commande d'absorbance (E2) est plus longue que l'absorbeur et s'étend au moins partiellement sur la section passive.

2. Laser selon la revendication 1, ce laser comportant un empilement des couches suivantes, ces couches se succédant selon une direction verticale de ce laser :
- une couche d'électrode inférieure (2) sous une face inférieure (3) d'une plaquette semiconductrice (4),
- une couche de confinement inférieure (6) appartenant à ladite plaquette semiconductrice et présentant un premier type de conductivité électrique et un indice de réfraction,
- une couche de guidage de lumière (8) comportant un guide de lumière (S1, S2, S3) constitué au moins partiellement d'un matériau semiconducteur en continuité cristalline avec cette couche de confinement inférieur et présentant un indice de réfraction supérieur à celui de cette couche de confinement inférieure, pour permettre de réaliser un confinement optique vertical dans cette couche de guidage,
- une couche de confinement supérieure (10) appartenant à ladite plaquette semiconductrice et présentant une continuité cristalline avec ce guide de lumière, un deuxième type de conductivité électrique opposé au premier, et un indice de réfraction inférieur à celui de ce guide de lumière pour réaliser ledit confinement optique vertical,
- et une couche d'électrodes supérieure (12) sur une face supérieure (14) de ladite plaquette semiconductrice,
- ledit guide de lumière (S1, S2, S3) s'étendant selon une direction longitudinale (X) dans ladite couche de guidage de lumière entre deux zones de confinement latérales (16, 18) dont des indices de réfraction sont choisis inférieurs à celui de ce guide pour réaliser un confinement optique transversal en confinant une lumière dans ce guide entre ces deux zones de confinement latérales, ce guide de lumière comportant une succession de sections selon ladite direction longitudinale d'arrière en avant, une première section étant un amplificateur de lumière (S1), une deuxième section étant un absorbeur saturable (S2) et constituant avec cet amplificateur un ensemble actif (S1, S2), cet ensemble actif étant constitué d'un matériau actif semiconducteur choisi pour agir sur une lumière d'émission qui se propage avec une longueur d'onde d'émission selon ladite direction longitudinale, ce matériau étant apte à être traversé par des courants électriques passant entre les deux dites couches de confinement inférieure et supérieure, une intensité de ce courant étant comptée algébriquement dans un sens direct par rapport aux types de conductivité de ces deux couches, ce matériau amplifiant cette lumière dans cet amplificateur lorsqu'un courant électrique traversant cet amplificateur présente une densité de courant supérieure à un seuil d'amplification et constitue alors un courant d'alimentation (I1), ce matériau absorbant cette lumière dans cet absorbeur lorsqu'un courant électrique traversant cet absorbeur présente une densité de courant inférieure à ce seuil d'amplification et constitue alors un courant de commande d'absorbance (I2), cet absorbeur absorbant une énergie nouvelle de cette lumière seulement dans la mesure où l'énergie de cette lumière qu'il a absorbée et accumulée pendant une période de conservation d'énergie est inférieure à une absorbance de cet absorbeur, cette période de conservation d'énergie ayant une durée limitée et précédant et incluant l'instant où cet absorbeur reçoit cette énergie nouvelle, cette absorbance étant commandée par ce courant de commande, une troisième section étant constituée d'un matériau passif choisi pour transmettre ladite lumière d'émission sans agir sensiblement ni sur son intensité ni sur sa vitesse de propagation, cette section constituant une section passive (S3),
- ladite couche d'électrodes supérieures comportant :
- une électrode d'alimentation (E1) localisée pour transmettre un dit courant d'alimentation (I1) vers ladite couche d'électrode inférieure (2) à travers ledit amplificateur (S1),
- et une électrode de commande d'absorbance (E2) localisée pour transmettre un dit courant de commande d'absorbance (I2) vers ladite couche d'électrode inférieure à travers ledit absorbeur (S2),
- ledit laser comportant encore :
- une source d'alimentation (20) pour fournir ledit courant d'alimentation à cette électrode d'alimentation,
- une source de commande d'absorbance (22, 23, 24, 26) pour fournir ledit courant de commande d'absorbance à ladite électrode de commande d'absorbance,
- et des moyens de réflexion de lumière (27, 28) disposés de part et d'autre longitudinalement dudit ensemble actif (S1, S2) pour que ladite plaquette semiconductrice (4) constitue un émetteur de lumière émettant ladite lumière d'émission.

3. Laser selon la revendication 2 caractérisé par le fait qu'il comporte un obstacle (C2) au courant électrique sur au moins certains des trajets qui vont de ladite électrode de commande d'absorbance (E2) à ladite couche d'électrode inférieure (2) en passant à travers ladite section passive (S3).

4. Laser selon la revendication 3 caractérisé par le fait que la résistivité électrique du dit matériau passif (S3) est sensiblement supérieure à celle dudit matériau actif (S1, S2).

5. Laser selon la revendication 3 caractérisé par le fait que des canaux d'isolation électrique arrière(C1) et avant (C2) sont formés dans ladite plaquette semiconductrice (4) à partir de sa dite face supérieure (14), ledit canal d'isolation avant (C2) étant localisé longitudinalement au voisinage d'un bord avant de ladite électrode de commande d'absorbance.

6. Laser selon la revendication 2 caractérisé par le fait que ladite plaquette semiconductrice (4) présente une face avant clivée (28) formant une extrémité avant de ladite section passive (S3).

7. Laser selon la revendication 2 caractérisé par le fait que lesdits amplificateur (S1) et absorbeur (S2) sont connectés optiquement à un composant optique (26) par l'intermédiaire de ladite section passive (S3).

8. Laser selon la revendication 2 dans lequel lesdites électrodes d'alimentation (E1) et de commande d'absorbance (E2) présentent la forme de rubans ayant, selon une direction transversale (Y), des longueurs supérieures à la largeur dudit guide de lumière (S1, S2, S3), des moyens de confinement électrique latéral étant prévus pour empêcher, au moins partiellement lesdits courants d'alimentation (I1) et de commande d'absorbance (I2) de passer à travers lesdites zones de confinement latérales (16, 18).

## Patentansprüche

1. Halbleiterlaser mit sättigungsfähigem Absorber, wobei drei in Längsrichtung aufeinanderfolgende Abschnitte eines Halbleiter-Lichtleiters einen Lichtverstärker (S1), einen sättigungsfähigen Absorber (S2) und einen passiven Abschnitt (S3) bilden und wobei eine Speiseelektrode (E1), um einen Speisestrom (I1) durch den Verstärker fließen zu lassen, und eine Absorptionssteuerelektrode (E2) auf diesem Laser angeordnet sind, um einen Absorptionssteuerstrom (I2) durch diesen Absorber fließen zu lassen, dadurch gekennzeichnet, daß die Absorptionssteuerelektrode (E2) länger als der Absorber ist und sich mindestens teilweise über den passiven Abschnitt erstreckt.

2. Laser nach Anspruch 1, der aus einer Stapelung der folgenden Schichten besteht, die in einer vertikalen Richtung des Lasers aufeinanderfolgen:
- eine untere Elektrodenschicht (2) unter einer Unterseite (3) eines Halbleiterplättchens (4),
- eine untere Einschließungsschicht (6), die Bestandteil dieses halbleitenden Plättchens ist und einen ersten Leitfähigkeitstyp sowie einen Brechungsindex besitzt,
- eine Lichtleiterschicht (8) mit einem Lichtleiter (S1, S2, S3), der zumindest teilweise aus Halbleitermaterial in kristalliner Kontinuität mit der unteren Einschließungsschicht besteht und einen größeren Brechungsindex als der der unteren Einschließungsschicht aufweist, um eine optische Einschließung in senkrechter Richtung in dieser Lichtleiterschicht zu ermöglichen,
- eine obere Einschließungsschicht (10), die Bestandteil des Halbleiterplättchens ist und eine kristalline Kontinuität mit dem Lichtleiter, einen zweiten elektrischen Leitfähigkeitstyp entgegengesetzt zum ersten und einen niedrigeren Brechungsindex besitzt als der Lichtleiter, um die optische Einschließung in senkrechter Richtung zu erzielen,
- und eine obere Elektrodenschicht (12) auf einer Oberseite (14) des halbleitenden Plättchens,
- wobei der Lichtleiter (S1, S2, S3) sich in einer Längsrichtung (X-Richtung) in der lichtleitenden Schicht zwischen zwei seitlichen Einschließungszonen (16, 18) erstreckt, deren Brechungsindex kleiner als der des Lichtleiters gewählt wird, um eine optische Einschließung in Querrichtung für das Licht in diesem Lichtleiter zwischen diesen beiden seitlichen Einschließungsschichten zu gewährleisten, wobei der Lichtleiter eine Folge von Abschnitten in Längsrichtung von hinten nach vorne enthält, nämlich: einen ersten Abschnitt, der ein Lichtverstärker (S1) ist, einen zweiten Abschnitt, der ein sättigungsfähiger Lichtabsorber (S2) ist und zusammen mit dem Verstärker eine aktive Einheit (S1, S2) bildet, die aus einem aktiven Halbleitermaterial besteht, das auf ein ausgesendetes Licht einwirkt, das sich mit einer Sendewellenlänge in dieser Längsrichtung ausbreitet, wobei dieses Material von elektrischen Strömen durchquert werden kann, die zwischen der unteren und der oberen Einschließungsschicht verlaufen und deren Stärke algebraisch in positiver Richtung bezüglich der Leitfähigkeitstypen dieser beiden Schichten gezählt wird, wobei dieses Material das Licht im Verstärker verstärkt, wenn ein den Verstärker durchquerender elektrischer Strom eine Stromdichte oberhalb einer Verstärkungsschwelle besitzt und also einen Speisestrom (I1) bildet, wobei dieses Material das Licht im Absorber absorbiert, wenn ein elektrischer Strom den Absorber mit einer Stromdichte unterhalb der Verstärkungsschwelle durchquert und somit einen die Absorptionsfähigkeit steuernden Strom (I2) bildet, wobei der Absorber eine neue Lichtenergie nur absorbiert, wenn die Energie des bereits absorbierten und während einer Energiespeicherperiode akkumulierten Lichts unter der Absorptionsgrenze liegt, wobei dieses Energiespeicherperiode eine begrenzte Dauer hat und dem Augenblick vorausgeht und ihn einschließt, in dem der Absorber diese neue Energie empfängt, wobei diese Absorptionsgrenze durch den Steuerstrom gesteuert wird, wobei ein dritter Abschnitt von einem solchen passiven Material gebildet wird, das das Sendelicht überträgt, ohne die Stärke oder die Fortpflanzungsgeschwindigkeit des Lichts nennenswert zu verändern, wobei dieser Abschnitt einen passiven Abschnitt (53) bildet, wobei die obere Elektrodenschicht enthält:
- eine Speiseelektrode (E1), die so angeordnet ist, daß sie einen Speisestrom (I1) zur unteren Elektrodenschicht (2) durch den Verstärker (S1) hindurch fließen läßt,
- und eine Steuerelektrode (E2) für die Absorption, die so angeordnet ist, daß sie einen Absorptionssteuerstrom (I2) zur unteren Elektrodenschicht (2) durch den Absorber (S2) hindurch fließen läßt,
wobei der Laser weiter enthält:
- eine Speisestromquelle (20), die den Speisestrom an die Speiseelektrode liefert,
- eine Stromquelle für die Absorptionssteuerung (22, 23, 24, 26), die den Absorptionssteuerstrom an die Steuerelektrode (E2) liefert,
- und Lichtreflexionsmittel (27, 28), die in Längsrichtung zu beiden Seiten der aktiven Einheit (S1, S2) liegen, so daß das Halbleiterplättchen (4) einen Lichtsender bildet, der das Sendelicht erzeugt.

3. Laser nach Anspruch 2, dadurch gekennzeichnet, daß er ein Hindernis (C2) für den elektrischen Strom auf mindestens manchen der Strecken besitzt, die von der Absorptionssteuerelektrode (E2) zur unteren Elektrodenschicht (2) durch den passiven Abschnitt (S3) verlaufen.

4. Laser nach Anspruch 3, dadurch gekennzeichnet, daß der spezifische elektrische Widerstand des passiven Materials (S3) deutlich größer als der des aktiven Materials (S1, S2) ist.

5. Laser nach Anspruch 3, dadurch gekennzeichnet, daß rückwärtige und vordere elektrische Isolationskanäle (C1, C2) in dem Halbleiterplättchen (4) ausgehend von dessen Oberseite (14) ausgebildet sind, wobei der vordere Isolationskanal (C2) in Längsrichtung in der Nähe eines vorderen Rands der Absorptionssteuerelektrode liegt.

6. Laser nach Anspruch 2, dadurch gekennzeichnet, daß das Halbleiterplättchen (4) eine vordere Spaltfläche (28) besitzt, die ein vorderes Ende des passiven Abschnitts (S3) bildet.

7. Laser nach Anspruch 2, dadurch gekennzeichnet, daß der Verstärker (S1) und der Absorber (S2) optisch mit einem optischen Bauelement (26) über den passiven Abschnitt (S3) gekoppelt sind.

8. Laser nach Anspruch 2, in dem die Speiseelektrode (E1) und die Absorptionssteuerelektrode (E2) die Form von Bändern besitzen, die in Querrichtung (Y) eine größere Länge als die Breite des Lichtleiters (S1, S2, S3) besitzen, und seitliche elektrische Einschließungsmittel vorgesehen sind, um zumindest teilweise die Speise- und Absorptionssteuerströme (I1, I2) daran zu hindern, durch die seitlichen Einschließungszonen (16, 18) zu fließen.

## Claims

1. A semiconductor laser with a saturable absorber, in which three successive sections of a longitudinal semiconductor light guide comprise a light amplifier (S1), a saturable absorber (S2) and a passive section (S3), a power supply electrode (E1) being disposed on the laser to pass a power supply current (I1) through the amplifier, an absorbance control electrode (E2) being disposed on the laser to pass an absorbance control current (I2) through the absorber, the laser being characterized in that the absorbance control electrode (E2) is longer than the absorber and extends at least partially over the passive section.

2. A laser according to claim 1, comprising the following stack of layers, in a vertical direction of the laser:
a bottom electrode layer (2) below a bottom face (3) of a semiconductor wafer (4),
a lower confining layer (6) pertaining to said semiconductor wafer and having a first electrical conductivity type and a refractive index,
a light guide layer (8) comprising a light guide (S1, S2, S3) formed at least partially of a semiconductor material in crystalline continuity with the lower confining layer and having a refractive index greater than that of the lower confining layer to effect vertical optical confinement within this guide layer,
an upper confining layer (10) pertaining to said semiconductor wafer and having crystalline continuity with the light guide, a second electrical conductivity type opposite to the first, and a refractive index lower than that of the light guide, to effect said vertical optical confinement, and
a top electrode layer (12) on a top face (14) of said semiconductor wafer,
said light guide (S1, S2, S3) extending in a longitudinal direction (X) in the light guide layer between two lateral confining regions (16, 18) whose refractive indices are selected to be lower than that of the guide to effect transverse optical confinement, confining light in the guide between these two lateral confining regions, the light guide comprising a sequence of sections along said longitudinal direction, from back to front, a first section being a light amplifier (S1), a second section being a saturable absorber (S2) and forming an active unit (S1, S2) with the amplifier, the active unit being constituted by an active semiconductor material selected to act with emission light which is propagated with an emission wavelength in the longitudinal direction, this material being adapted to be traversed by electrical currents passing between the two said upper and lower confining layers, such currents being measured algebraically in the forwards direction relative to the conductivity types of these two layers, this material amplifying the light in the amplifier when an electrical current flowing in the amplifier has a current density above a threshold of amplification, this current thus forming a power supply current (I1), the material absorbing the light in the absorber when the electrical current flowing in the absorber has a current density below the threshold of amplification, thus forming an absorbance control current (I2), the absorber absorbing fresh energy from the light only to the extent that the light energy which has already been absorbed and accumulated during an energy storage interval is lower than an absorbance of the absorber, this energy storage interval having a limited duration and preceding and including the instant at which the absorber receives the new energy, the absorbance being controlled by the control current, a third section being formed by a passive material selected to transmit said emission light without appreciably affecting either its intensity or its speed of propagation, this section forming a passive section (S3),
said upper electrode layer comprising:
a power supply electrode (E1) disposed to transmit the power supply current (I1) towards said bottom electrode layer (2) through said amplifier (S1),
and an absorbance control electrode (E2) disposed to transmit the absorbance control current (I2) towards said bottom electrode layer through said absorber (S2),
said laser further comprising:
a power supply source (20) to provide said power supply current to the power supply electrode,
an absorbance control source (22, 23, 24, 26) to supply said absorption control current to said absorbance control electrode,
and light reflecting means (27, 28) located on the two ends of the active unit (S1, S2) so that said semiconductor wafer (4) forms a light emitter emitting said emission light.

3. A laser according to claim 2, characterized in that it comprises a barrier (C2) to electrical current in at least some of the paths leaving the absorbance control electrode (E2) for the for the bottom electrode layer (2) and passing though the passive section (S3).

4. A laser according to claim 3, characterized in that the electrical resistivity of said passive material (S3) is substantially greater than that of said active material (S1, S2).

5. A laser according to claim 3, characterized in that rear and front electrically insulating channels (C1 and C2) are formed in the semiconductor wafer from its top face (14), said front insulating channel (C2) being located longitudinally in the vicinity of the front edge of said absorbance control electrode.

6. A laser according to claim 2, characterized in that said semiconductor wafer has a front cleavage face (28) forming a front end of said passive section (S3).

7. A laser according to claim 2, characterized in that said amplifier (S1) and absorber (S2) are optically coupled to an optical device (26) through said passive section (S3).

8. A laser according to claim 2, in which said power supply and absorbance control electrodes (El and E2) are in the form of strips having a length in a transverse direction (Y) greater than the width of said light guide (S1, S2, S3), electrical lateral confining means being provided to prevent at least partially said power supply and absorption control currents (I1 and I2) passing though said lateral confining layers (16, 18).
